# EUROPEAN PATENT APPLICATION

(11) **EP 4 661 608 A2**
(43) Date of publication of application: **10.12.2025**
(21) Application number: 25180253.4
(22) Date of filing: 02.06.2025
(51) Int. Cl.: H05K 7/14

(54) **POWER EXPANSION KIT FOR A DIRECT CURRENT SYSTEM**

(30) Priority: 07.06.2024 IN 202421044360; 28.05.2025 US 202519220874
(71) Applicant: Vertiv Corporation, Westerville, OH 43082 (US)
(72) Inventor: Larsson, Pär, Westerville, 43082 (US); Sam, Yahya, Westerville, 43082 (US); Vichare, Omkar, Westerville, 43082 (US)
(74) Representative: Cousens, Nico

(57) **Abstract**

A power expansion kit includes a connection box. The connection box may include a slot configured to engage with one or more slots of one or more power shelves. The power expansion kit further includes one or more fork plugs. The one or more fork plugs may be arranged on a backside of the connection box. The one or more fork plugs may be configured to electrically couple to one or more busbars of a direct current power unit.

## Description

**The** present application claims the benefit of India Provisional Application No. 202421044360, filed on June 7, 2024.

### TECHNICAL FIELD

The present disclosure relates to the field of electrical engineering, and more specifically, the present disclosure relates to a power expansion kit for a direct current (DC) system.

### BACKGROUND

Power expansion kits serve as vital intermediary components, bridging existing live direct current (DC) systems with additional power shelves without disrupting the ongoing power supply to essential equipment such as radio stations or data systems. Conventional systems frequently require interruption of the power supply during expansion, leading to downtime and operational disruptions for end-users. Moreover, connecting additional shelves to the basic power system for expansion purposes is challenging due to the complexities of accessing the backside busbars of the DC systems. These challenges significantly delay the efficiency and ease of the expansion process, hampering overall comfort and convenience. Further, these limitations not only delay the scalability of power systems but also delay logistical footraces in terms of installation and maintenance. Consequently, there exists a clear gap in the market for a solution that could facilitate seamless power expansion without compromising operational continuity or system integrity.

There is, therefore felt a need for a power expansion kit for the DC system that alleviates the aforementioned drawbacks.

### SUMMARY

In embodiments, a power system including: a direct current (DC) power unit including one or more power shelves configured to provide a primary power source for the power system, where the one or more power shelves include a plurality of slots, where the plurality of slots include at least an expansion slot and one or more rectifier slots, where the one or more rectifier slots include one or more rectifier units, where the one or more rectifier units are configured to convert alternating current (AC) power to DC power; one or more busbars arranged on a backside of the DC power unit; one or more expansion power shelves configured to provide a secondary power source for the power system, where the one or more expansion power shelves include a plurality of additional slots, where the plurality of additional slots include at least an additional expansion slot and one or more additional rectifier slots, where the one or more additional rectifier slots include one or more additional rectifier units, where the one or more additional rectifier units are configured to convert alternating current (AC) power to DC power; and a power expansion kit, where the power expansion kit includes: a connection box, where the expansion slot of the one or more power shelves and the additional expansion slot of the one or more expansion power shelves are configured to receive at least a portion of the connection box; and one or more fork plugs, where the one or more fork plugs are arranged on a backside of the connection box, where the one or more fork plugs are configured to electrically couple to one or more backside busbars, where the one or more backside busbars are electrically coupled to the one or more busbars of the DC power unit.

In embodiments, a power expansion kit including: a connection box, where the connection box includes a slot, where the connection box is configured to engage with one or more slots of one or more power shelves; and one or more fork plugs, where the one or more fork plugs are arranged on a backside of the connection box, where the one or more fork plugs are configured to electrically couple to one or more busbars of a direct current (DC) power unit via one or more back busbars.

In embodiments, a power system including: a direct current (DC) power unit including one or more power shelves configured to provide a primary power source for the power system, where the one or more power shelves include a plurality of slots, where the plurality of slots include at least an expansion slot and one or more rectifier slots, where the one or more rectifier slots include one or more rectifier units, where the one or more rectifier units are configured to convert alternating current (AC) power to DC power; one or more busbars arranged on a backside of the DC power unit; one or more expansion power shelves configured to provide a secondary power source for the power system, where the one or more expansion power shelves include a plurality of additional slots, where the plurality of additional slots include at least an additional expansion slot and one or more additional rectifier slots, where the one or more additional rectifier slots include one or more additional rectifier units, where the one or more additional rectifier units are configured to convert alternating current (AC) power to DC power; and a power expansion kit, where the power expansion kit includes: a connection box, where the expansion slot of the one or more power shelves and the additional expansion slot of the one or more expansion power shelves are configured to receive at least a portion of the connection box, where the connection box the power expansion kit includes a slot, where the slot of the connection box is configured to slide between a bottom surface of the expansion slot of the one or more power shelves and a top surface of the additional expansion slot of the one or more expansion power shelves; and a plurality of fork plugs, where the plurality of fork plugs include at least a first set of fork plugs on a top backside portion of the connection box and a second set of fork plugs on a bottom backside power of the connection box, where the first set of fork plugs are configured to electrically couple to a first back busbar on the one or more power shelves and the second set of fork plugs are configured to electrically couple to a second back busbar on the one or more expansion power shelves.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE DRAWINGS

The numerous advantages of the disclosure may be better understood by those skilled in the art by reference to the accompanying figures.
FIG. 1A illustrates a front view of a system including a direct current (DC) power unit and an additional power shelf, in accordance with one or more embodiments of the present disclosure.
FIG. 1B illustrates a front perspective view of the system including the DC power unit and the additional power shelf, in accordance with one or more embodiments of the present disclosure.
FIG. 1C illustrates a side view of the system including the DC power unit and the additional power shelf, in accordance with one or more embodiments of the present disclosure.
FIG. 1D illustrates a side perspective view of the system including the DC power unit and the additional power shelf, in accordance with one or more embodiments of the present disclosure.
FIG. 1E illustrates a rear perspective view of the system including the DC power unit and the additional power shelf, in accordance with one or more embodiments of the present disclosure.
FIG. 1F illustrates a rear perspective view of the system including the DC power unit and the additional power shelf, in accordance with one or more embodiments of the present disclosure.
FIG. 2 illustrates a front perspective view of an expansion kit for the system, in accordance with one or more embodiments of the present disclosure.
FIG. 3A illustrates a front perspective view of the system and the expansion kit, in accordance with one or more embodiments of the present disclosure.
FIG. 3B illustrates a side view of the system and the expansion kit, in accordance with one or more embodiments of the present disclosure.
FIG. 3C illustrates a front perspective view of the system and the expansion kit, in accordance with one or more embodiments of the present disclosure.
FIG. 3D illustrates a side perspective view of the system including the expansion kit, in accordance with one or more embodiments of the present disclosure.
FIG. 3E illustrates a front perspective view of the system including the expansion kit, in accordance with one or more embodiments of the present disclosure.
FIG. 3F illustrates a rear perspective view of the DC power system including the expansion kit, in accordance with one or more embodiments of the present disclosure.

### DETAILED DESCRIPTION

Reference will now be made in detail to the subject matter disclosed, which is illustrated in the accompanying drawings.

Power expansion kits serve as vital intermediary components, bridging existing live direct current (DC) systems with additional power shelves without disrupting the ongoing power supply to essential equipment such as radio stations or data systems. Conventional systems frequently require interruption of the power supply during expansion, leading to downtime and operational disruptions for end-users. Moreover, connecting additional shelves to the basic power system for expansion purposes is challenging due to the complexities of accessing the backside busbars of the DC systems. These challenges significantly delay the efficiency and ease of the expansion process, hampering overall comfort and convenience. Further, these limitations not only delay the scalability of power systems but also delay logistical footraces in terms of installation and maintenance. Consequently, there exists a clear gap in the market for a solution that could facilitate seamless power expansion without compromising operational continuity or system integrity.

Embodiments of the present disclosure are directed to a power expansion system for a live DC power unit. For example, the system may include an expansion kit configured to connect a live DC unit and one or more additional power shelves. In this regard, the power expansion system may be configured to provide uninterrupted power expansion and enable easy and quick front-side installation. Further, the power expansion system may improve the reliability of the power supply and allow for easy and trouble-free expansion.

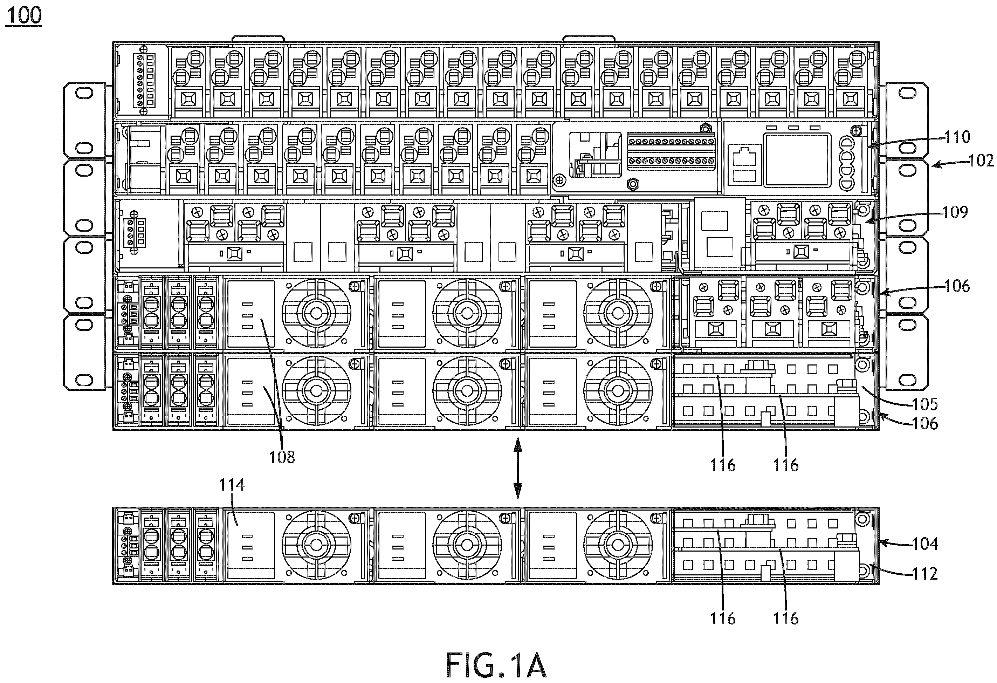

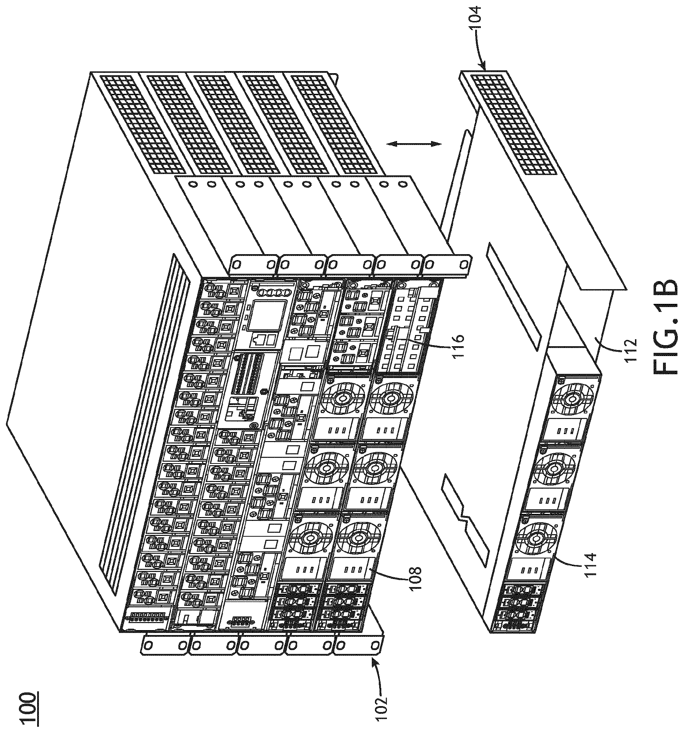

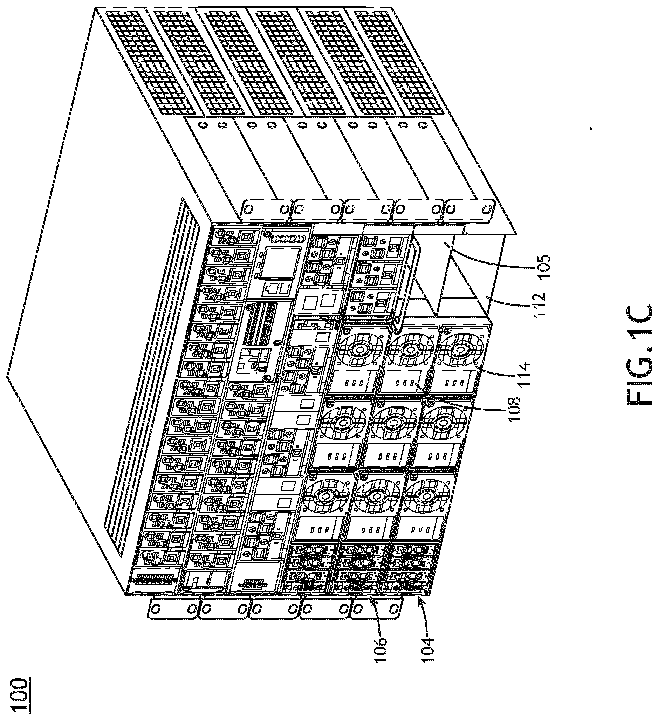

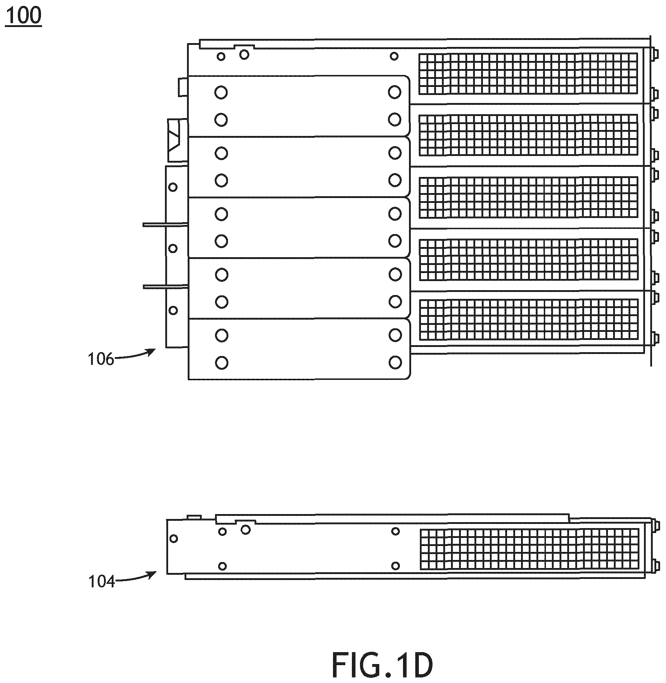

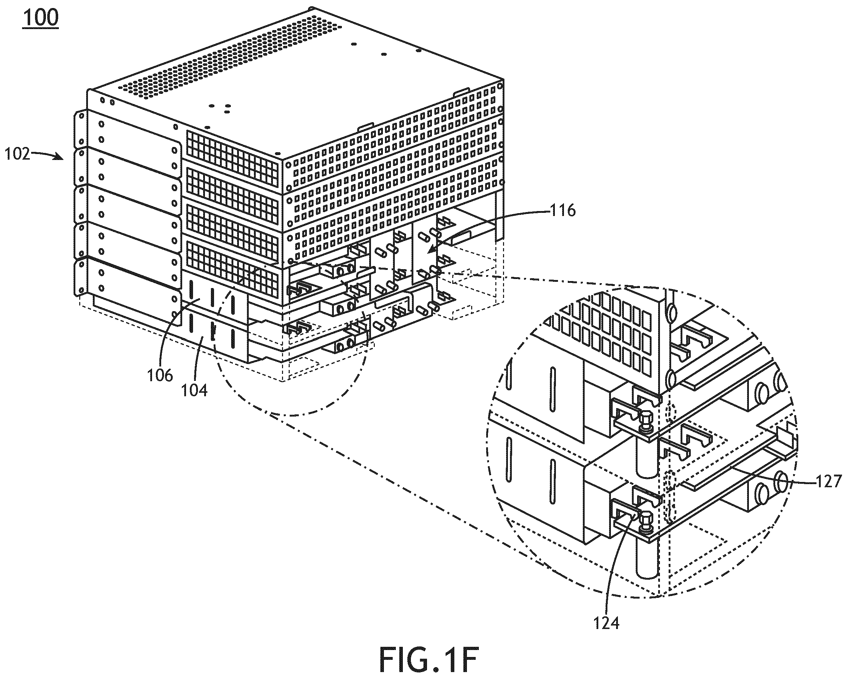

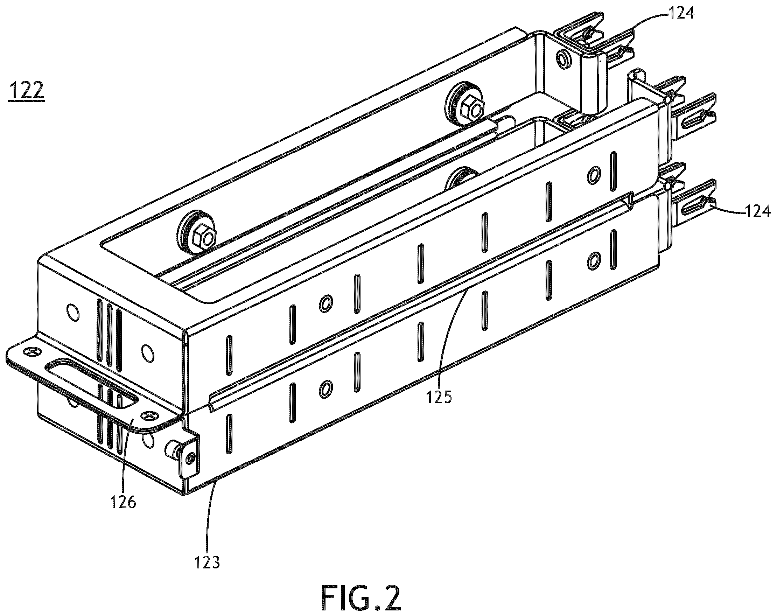

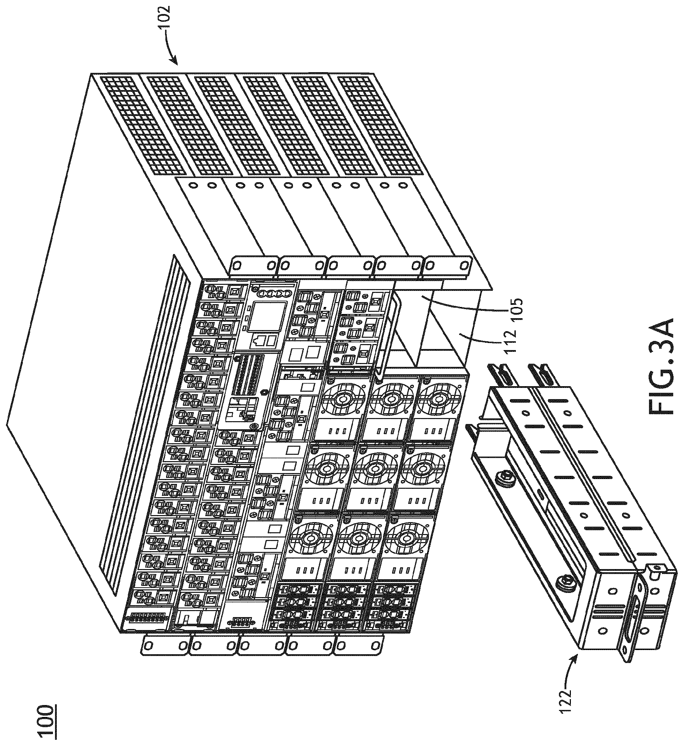

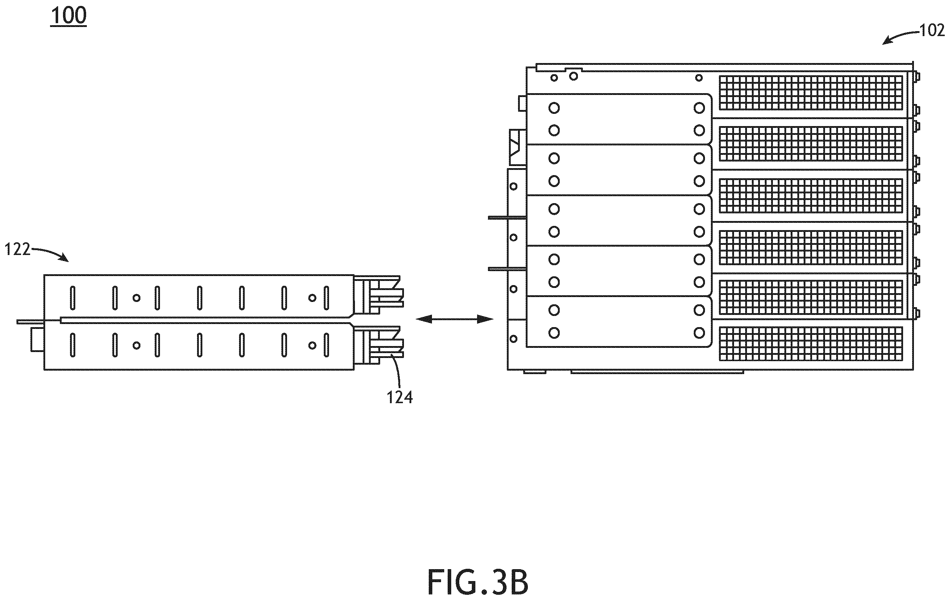

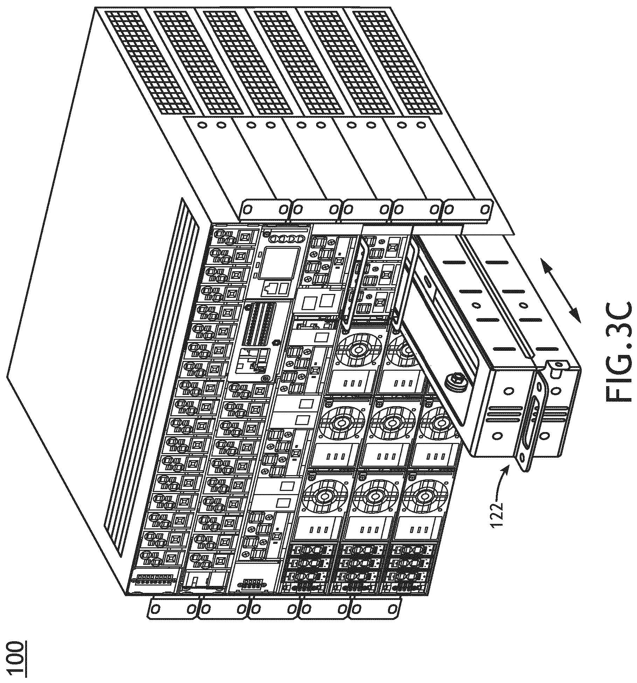

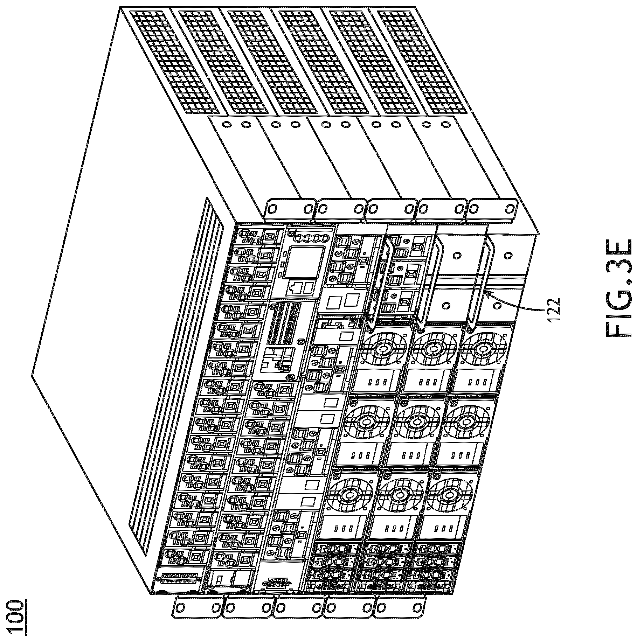

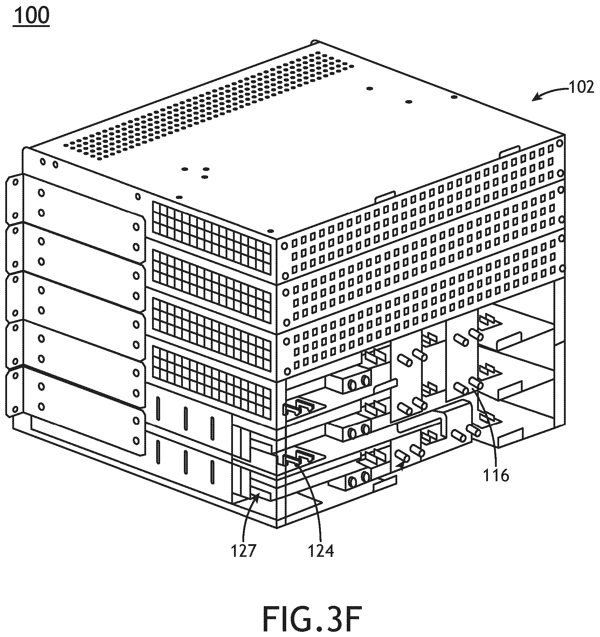

FIGS. 1A-1F illustrate a power expansion system 100 including a direct current (DC) power unit 102 and one or more expansion power shelves 104, in accordance with one or more embodiments of the present disclosure. FIG. 2 illustrates an expansion kit 122 of the power expansion system 100. FIGS. 3A-3F illustrate the power expansion system 100 and the expansion kit 122, in accordance with one or more embodiments of the present disclosure.

In embodiments, the DC power unit 102 includes one or more rectifier shelves 106 (or power shelves). Each rectifier shelf 106 may include a plurality of slots 105. For example, one or more slots of the plurality of slots 105 may be configured to receive one or more rectifier units 108 configured to convert alternating current (AC) to direct current (DC). In this regard, the DC power unit 102 may be configured to enhance the performance and reliability of the system 100 by accommodating the need for stable and consistent power conversion. As will be discussed further herein, one or more additional slots of the plurality of slots 105 may be configured to couple to an expansion power kit 122.

Each rectifier unit 108 may include one or more indicator lights. For example, the rectifier unit 108 may include at least one of a power indicator light, protection indicator light, or an alarm indicator light (e.g., on a face plate of the rectifier unit 108). The rectifier unit 108 may include a fan within a housing of the rectifier unit 108, where a faceplate covers at least the front face of the rectifier unit 108.

It is contemplated herein that DC power unit 102 may be a live DC power unit. In this regard, the live DC power unit 102 may continue to power equipment during power expansion, as will be discussed further herein.

The DC power unit 102 may further include, but is not limited to, one or more control units 110, one or more solar converters, or other power components.

In embodiments, the power system 100 is configured to receive one or more expansion power shelves 104. For example, the one or more expansion power shelves 104 may be added to the DC power unit 102 to enable power expansion. For instance, as shown in FIGS. 1A-1C, an expansion power shelf 104 may be installed below the bottom rectifier shelf 106 of the DC power unit 102 to connect the one or more expansion power shelves 104. In some embodiments, the expansion power shelf 104 may be mechanically coupled to the DC power unit 102. For example, the expansion power shelf 104 may be mechanically coupled to the DC power unit 102 on-site. For instance, the system 100 may further include one or more bolts 118. For example, the one or more bolts 118 may be configured to couple together the DC power unit 102 and the expansion power shelves 104, ensuring that the components are stable and properly aligned.

The one or more expansion power shelves 104 may include a plurality of slots 112. For example, one or more of the plurality of slots 112 may be configured to receive one or more additional rectifier units 114. The one or more additional rectifier units 114 may be configured to serve as a power supply by converting AC to DC power. As will be discussed further herein, one or more additional slots of the plurality of slots 112 may be configured to couple to an expansion power kit 122.

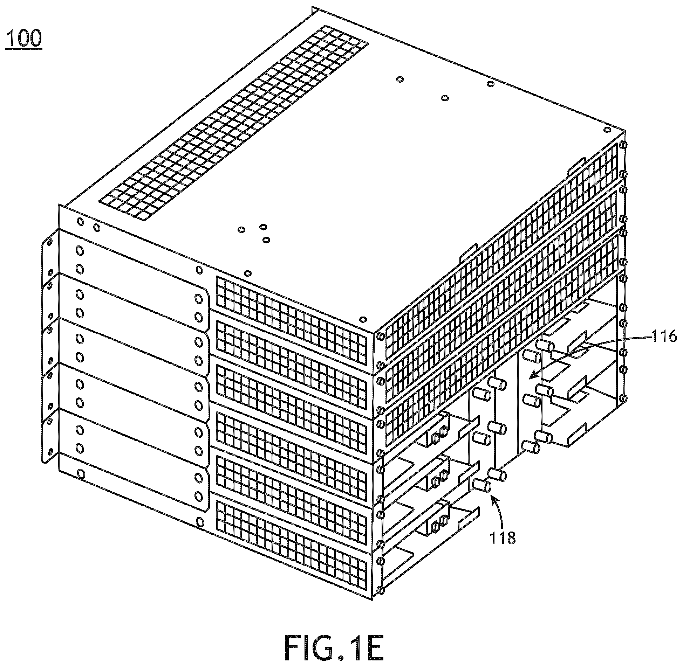

Referring to FIG. 1E, the system 100 may further include one or more busbars 116 configure to distribute electrical power through the one or more power shelves 104, 106. For example, the one or more busbars 116 may be on a backside of the DC power unit 102. The one or more busbars 116 may be configured to connect various components such as, but not limited to, circuit breakers, switches, and power sources, thus enabling efficient power distribution throughout the system 100.

Referring to FIGS. 2-3F, in embodiments, the system 100 includes a power expansion kit 122. For example, the power expansion kit 122 may be configured to boost the power capacity of an electrical system by integrating additional power sources such as rectifiers to meet higher energy demands. In embodiments, the one or more expansion power shelves 104 and the one or more rectifier shelves 106 are configured to receive the power expansion kit 122. For example, the plurality of slots 105 of the one or more rectifier shelves 106 and the plurality of slots 112 of the one or more expansion power shelves 104 may be configured to receive a portion of the expansion kit 122.

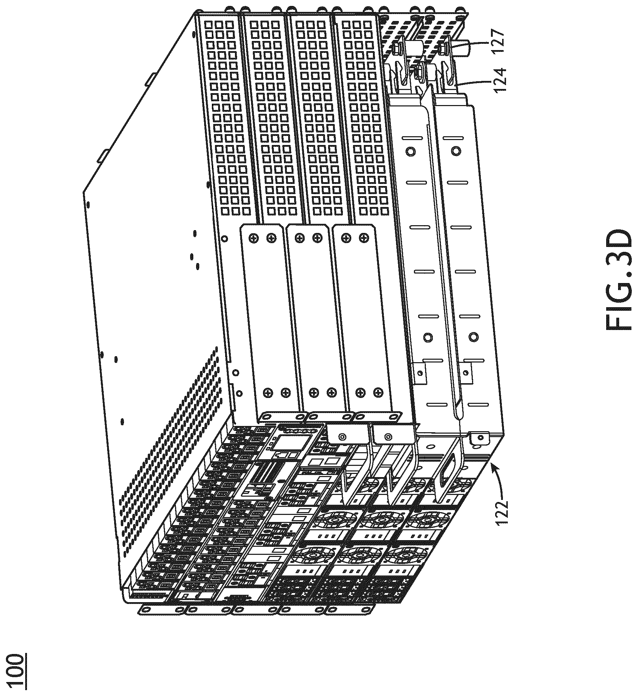

The power expansion kit 122 includes a connection box 123. The connection box 123 may include a slot 125. For example, as shown in FIG. 3D, the slot 125 of the connection box 123 may be configured to slide between a bottom surface of the expansion slot 105 of the one or more power shelves 106 and a top surface of the additional expansion slot 112 of the one or more expansion power shelves 104. In some instances, the expansion slot 112 may be covered by a plate cover 109 when not in use.

In embodiments, the power expansion kit 122 includes one or more fork plugs 124. For example, the one or more fork plugs 124 may be configured to electrically couple to a portion of one or more back busbars 127. For instance, the one or more fork plugs 124 may be configured to slide onto the one or more back busbars 127 to establish a secure electrical connection. In this regard, the power expansion kit 122 is able to provide additional power capacity to the DC power unit 102. The one or more back busbars 127 may be electrically connected to the one or more busbars 116 of the DC power unit 102.

In a non-limiting example, as shown in FIG. 2, the power expansion kit includes four fork plugs, where the four fork plugs include at least a top set of fork plugs on a top backside portion of the connection box and a bottom set of fork plugs on a bottom backside portion of the connection box. Continuing with this example, the top set of fork plugs may be configured to electrically couple to the one or more back busbars 127 of the one or more rectifier shelves 106 and the bottom set of fork plugs may be configured to electrically couple to the one or more back busbars 127 of the one or more expansion power shelves 104.

The power expansion kit 122 may further include a handle 126. For example, the handle 126 may be arranged on a front surface of the power expansion kit 122 to allow for easy installation and/or removal.

It is contemplated herein that while the one or more rectifier shelves 106 of the DC unit 102 handle the primary power conversion, the one or more expansion shelves 104 may be configured to increase the overall power output and redundancy of the system 100 (e.g., to serve as the secondary power source). In this regard, the system 100 may perform better under higher loads.

Further it is contemplated herein that although the power expansion kit 122 itself does not generate power, the power expansion kit 122 may facilitate the delivery of extra power to the system 100 via the added expansion rectifier shelf 104. As such, the augmented power strengthens the system's 100 capabilities, potentially enabling it to handle more demanding tasks or greater workloads with increased efficiency.

Also disclosed are the following numbered clauses:
1. A power system comprising: a direct current "DC" power unit including one or more power shelves configured to provide a primary power source for the power system, wherein the one or more power shelves include a plurality of slots, wherein the plurality of slots include at least an expansion slot and one or more rectifier slots, wherein the one or more rectifier slots include one or more rectifier units, wherein the one or more rectifier units are configured to convert alternating current "AC" power to DC power; one or more busbars arranged on a backside of the DC power unit; one or more expansion power shelves configured to provide a secondary power source for the power system, wherein the one or more expansion power shelves include a plurality of additional slots, wherein the plurality of additional slots include at least an additional expansion slot and one or more additional rectifier slots, wherein the one or more additional rectifier slots include one or more additional rectifier units, wherein the one or more additional rectifier units are configured to convert alternating current "AC" power to DC power; and a power expansion kit, wherein the power expansion kit comprises: a connection box, wherein the expansion slot of the one or more power shelves and the additional expansion slot of the one or more expansion power shelves are configured to receive at least a portion of the connection box, wherein the connection box the power expansion kit includes a slot, wherein the slot of the connection box is configured to slide between a bottom surface of the expansion slot of the one or more power shelves and a top surface of the additional expansion slot of the one or more expansion power shelves; and a plurality of fork plugs, wherein the plurality of fork plugs include at least a first set of fork plugs on a top backside portion of the connection box and a second set of fork plugs on a bottom backside power of the connection box, wherein the first set of fork plugs are configured to electrically couple to a first back busbar on the one or more power shelves and the second set of fork plugs are configured to electrically couple to a second back busbar on the one or more expansion power shelves.
2. The power system of clause 1, further comprising: a handle, wherein the handle is on a front surface of the connection box.
3. The power system of clause 1 or 2, wherein one of the one or more rectifier units or the one or more additional rectifier units include one or more indicator lights on a face plate of the one or more rectifier units or the one or more additional rectifier units.

Embodiments are provided so as to thoroughly and fully convey the scope of the present disclosure to the person skilled in the art. Numerous details are set forth relating to specific components, and methods, to provide a complete understanding of embodiments of the present disclosure. It will be apparent to the person skilled in the art that the details provided in the embodiments should not be construed to limit the scope of the present disclosure. In some embodiments, well-known processes, well-known apparatus structures, and well-known techniques are not described in detail.

The terminology used, in the present disclosure is only for the purpose of explaining a particular embodiment and such terminology shall not be considered to limit the scope of the present disclosure. As used in the present disclosure, the forms "a," "an," and "the" may be intended to include the plural forms as well, unless the context clearly suggests otherwise. The terms "comprises," "comprising," "including," and "having," are open-ended transitional phrases and therefore specify the presence of stated features, elements, modules, units and/or components, but do not forbid the presence or addition of one or more other features, elements, components, and/or groups thereof.

The foregoing description of the embodiments has been provided for purposes of illustration and is not intended to limit the scope of the present disclosure. Individual components of a particular embodiment are generally not limited to that particular embodiment but are interchangeable. Such variations are not to be regarded as a departure from the present disclosure, and all such modifications are considered to be within the scope of the present disclosure.

The present disclosure described herein above has several technical advantages including, but not limited to, the system for the power expansion kit, which: allows for the increase of DC power capacity without disrupting the power supply to critical systems; facilitates easy and quick installation from the front; reduces setup time and minimizes downtime; designed for effortless and trouble-free expansion;

The embodiments herein and the various features and advantageous details thereof are explained with reference to the non-limiting embodiments in the following description. Descriptions of well-known components and processing techniques are omitted so as to not unnecessarily obscure the embodiments herein. The examples used herein are intended merely to facilitate an understanding of ways in which the embodiments herein may be practiced and to further enable those of skill in the art to practice the embodiments herein. Accordingly, the examples should not be construed as limiting the scope of the embodiments herein.

The foregoing description of the specific embodiments so fully reveals the general nature of the embodiments herein that others can, by applying current knowledge, readily modify and/or adapt for various applications such specific embodiments without departing from the generic concept, and, therefore, such adaptations and modifications should and are intended to be comprehended within the meaning and range of equivalents of the disclosed embodiments. It is to be understood that the phraseology or terminology employed herein is for the purpose of description and not of limitation. Therefore, while the embodiments herein have been described in terms of preferred embodiments, those skilled in the art will recognize that the embodiments herein can be practiced with modification within the spirit and scope of the embodiments as described herein.

The use of the expression "at least" or "at least one" suggests the use of one or more elements or ingredients or quantities, as the use may be in the embodiment of the disclosure to achieve one or more of the desired objects or results.

Any discussion of devices, articles or the like that has been included in this specification is solely for the purpose of providing a context for the disclosure. It is not to be taken as an admission that any or all of these matters form a part of the prior art base or were common general knowledge in the field relevant to the disclosure as it existed anywhere before the priority date of this application.

While considerable emphasis has been placed herein on the components and component parts of the preferred embodiments, it will be appreciated that many embodiments can be made and that many changes can be made in the preferred embodiments without departing from the principles of the disclosure. These and other changes in the preferred embodiment as well as other embodiments of the disclosure will be apparent to those skilled in the art from the disclosure herein, whereby it is to be distinctly understood that the foregoing descriptive matter is to be interpreted merely as illustrative of the disclosure and not as a limitation.

## Claims

1. A power system (100) comprising:
a direct current "DC" power unit (102) including one or more power shelves configured to provide a primary power source for the power system, wherein the one or more power shelves include a plurality of slots (112), wherein the plurality of slots include at least an expansion slot (112) and one or more rectifier slots, wherein the one or more rectifier slots include one or more rectifier units (108), wherein the one or more rectifier units are configured to convert alternating current "AC" power to DC power;
one or more busbars (116) arranged on a backside of the DC power unit;
one or more expansion power shelves (104) configured to provide a secondary power source for the power system, wherein the one or more expansion power shelves include a plurality of additional slots, wherein the plurality of additional slots include at least an additional expansion slot and one or more additional rectifier slots, wherein the one or more additional rectifier slots include one or more additional rectifier units, wherein the one or more additional rectifier units are configured to convert alternating current "AC" power to DC power; and
a power expansion kit (122), wherein the power expansion kit comprises:
a connection box (123), wherein the expansion slot of the one or more power shelves and the additional expansion slot of the one or more expansion power shelves are configured to receive at least a portion of the connection box; and
one or more fork plugs (124), wherein the one or more fork plugs are arranged on a backside of the connection box, wherein the one or more fork plugs are configured to electrically couple to one or more backside busbars, wherein the one or more backside busbars are electrically coupled to the one or more busbars of the DC power unit.

2. The power system of claim 1, wherein the connection box the power expansion kit includes a slot, wherein the slot of the connection box is configured to slide between a bottom surface of the expansion slot of the one or more power shelves and a top surface of the additional expansion slot of the one or more expansion power shelves.

3. The power system of claim 1 or 2, wherein the power expansion kit further comprises a handle (126), wherein the handle is on a front surface of the connection box.

4. The power system of any preceding claim, wherein the one or more expansion power shelves couple to a bottom power shelf of the one or more power shelves of the DC power unit.

5. The power system of any preceding claim, wherein one of the one or more rectifier units or the one or more additional rectifier units include one or more indicator lights on a face plate of the one or more rectifier units or the one or more additional rectifier units.

6. The power system of any preceding claim, wherein the one or more power shelves of the DC power unit include three rectifier units.

7. The power system of any preceding claim, wherein the DC power unit includes at least a first power shelf of the one or more power shelves and a second power shelf of the one or more power shelves, wherein the expansion slot of the first power shelf is coupled to a plate cover (109), wherein the expansion slot of the second power shelf is configured to couple to the one or more fork plugs of the power expansion kit.

8. The power system of any preceding claim, wherein the one or more expansion power shelves include three rectifier units.

9. The power system of any preceding claim, wherein the power expansion kit includes four fork plugs.

10. The power system of claim 9, wherein the four fork plugs include a top set of fork plugs on a top portion of the connection box and a bottom set of fork plugs on the bottom portion of the connection box.

11. The power system of claim 10, wherein the top set of fork plugs are configured to electrically couple to a first back busbar on the one or more power shelves and the bottom set of fork plugs are configured to electrically couple to a second back busbar on the one or more expansion power shelves.

12. A power expansion kit (122) comprising:
a connection box (123), wherein the connection box includes a slot, wherein the connection box is configured to engage with one or more slots of one or more power shelves; and
one or more fork plugs (124), wherein the one or more fork plugs are arranged on a backside of the connection box, wherein the one or more fork plugs are configured to electrically couple to one or more busbars of a direct current "DC" power unit via one or more back busbars.

13. The power expansion kit of claim 12, wherein the slot of the connection box is configured to slide between a bottom surface of a first expansion slot of the one or more power shelves and a top surface of an additional expansion slot of the one or more power shelves.

14. The power expansion kit of claim 12 or 13, further comprising four fork plugs and/or a handle (126), wherein the handle is on a front surface of the connection box.

15. The power expansion kit of claim 14, wherein the four fork plugs include a top set of fork plugs on a top portion of the connection box and a bottom set of fork plugs on the bottom portion of the connection box, and optionally
wherein the top set of fork plugs are configured to electrically couple to a first back busbar on a first power shelf and the bottom set of fork plugs are configured to electrically couple to a second back busbar on a second power shelf.
